# EUROPEAN PATENT SPECIFICATION

(11) **EP 3 107 271 B1**
(45) Date of publication and mention of the grant of the patent: **28.02.2018**
(21) Application number: 16174630.0
(22) Date of filing: 15.06.2016
(51) Int. Cl.: H04M 1/02, H04M 1/22, H01Q 1/24

(54) **ELECTRONIC DEVICE**
ELEKTRONISCHE VORRICHTUNG
DISPOSITIF ÉLECTRONIQUE

(30) Priority: 16.06.2015 KR 20150085136
(43) Date of publication of application: 21.12.2016
(73) Proprietor: Samsung Electronics Co., Ltd., Gyeonggi-do 16677 (KR)
(72) Inventor: PARK, Jung-Min, 16677 Gyeonggi-do (KR)
(74) Representative: HGF Limited

(56) References cited:
- EP-A1- 2 200 261
- EP-A1- 2 725 767
- US-A1- 2012 157 175

## Description

### TECHNICAL FIELD

Various embodiments of the present disclosure relate to an electronic device. For example, various embodiments of the present disclosure relate to an electronic device in which at least a portion of a case member is formed as a conductive element.

### BACKGROUND

Typically, an electronic device refers to a device that performs a specific function according to an equipped program (e.g., an electronic scheduler, a portable multimedia reproducer, a mobile communication terminal, a tablet PC, an image/sound device, a desktop/laptop PC, or a vehicular navigation system), as well as a home appliance. For example, such an electronic device may output information stored therein as sound or an image. As the degree of integration of such an electronic device has increased and super-high speed and large capacity wireless communication has become popular, various functions have recently been equipped in a single electronic device, such as a mobile communication terminal. For example, an entertainment function (e.g., a game function), a multimedia function (e.g., a music/video reproducing function), a communication and security function for mobile banking, a schedule management function, and an e-wallet function are integrated in a single electronic device, in addition to a communication function, and more diverse functions can be implemented through networks.

Users' demands for performance improvements for such an electronic device have gradually increased, and the demand level for an exterior design has also gradually increased. In consideration of the easiness of manufacturing or mass production of the electronic device, the case member of the electronic device may be made of a synthetic resin material. In addition, a case member, which forms an exterior appearance, may be made of a metallic material in order to secure the reliability or design gentrification of the electronic device according to the users' demands as described above.

In the case where the case member of the electronic device is made of a metallic material, the radiation performance of an antenna device may be degraded. Accordingly, in a structure where the case member of the electronic device is made of a metallic material, a portion of the case member may be electrically insulated from other portions in order to utilize the portion as an antenna device. However, the material used for insulating the portion of the case member may degrade the external appearance of the electronic device due to its disparate feeling with respect to the metallic material. For example, the arrangement of an insulative material may damage an advantageous design aspect that can be obtained by using a metal-made case member.

US2012/157175 A1 discloses an electronic device such as a handheld device having a rectangular housing with a rectangular periphery. A conductive peripheral housing member may run along the rectangular periphery and may surround the rectangular housing. Radio-frequency transceiver circuitry within the electronic device may be coupled to antenna structures for transmitting and receiving radio-frequency signals. The conductive peripheral housing member may form part of the antenna structures. A gap in the conductive peripheral housing member may be filled with dielectric. The conductive peripheral housing member may be configured to form a recess. The recess may have the shape of a rectangle, oval, diamond, or other shape that overlaps and is bisected by the gap. The recess may also have the shape of a groove that extends around the entire periphery of the housing. The dielectric in the recess may include one or more different materials such as clear and opaque polymers.

EP2200261 A1 discloses a light-emitting device of a portable communication terminal which claims to improve exterior decoration by emitting light to the exterior of the portable communication terminal and implements a sense of unity of a design in a non-light emission state by integrating a portion to which the light is transmitted with a main body housing. The light-emitting device includes a housing, a light-emitting element for emitting light, a light guide sheet for guiding the light from the light-emitting element, and a light-transmitting portion integrally formed on the housing for transmitting the light from one end of the light guide sheet to an outer side of the housing. It claims that a sense of unity of the main body housing and the light-transmitting portion can be improved by applying a non-conductive vacuum metallizing (NCVM) process to the exterior. An aesthetic sense may be improved with the sense of unity of the exterior design.

### SUMMARY

To address the above-discussed deficiencies, it is a primary object to provide an electronic device, in which a metal-made case member is able to make the external appearance beautiful while being partially utilized as an antenna device.

In addition, various embodiments of the present disclosure are to provide an electronic device, in which a material for partially insulating a case member is utilized as an ornamental element such that the exterior appearance of the electronic device can be diversified.

An electronic device, according to various embodiments, may include: a case member that includes conductive elements that form a side wall around one face of the case member, and an insulative element that is at least partially provided between the conductive elements; and a light source that is disposed inside the case member. The insulative element may emit and/or transmit light, which is emitted from the light source, to the outside of the case member.

The insulative element may be partially positioned on at least one of a side face, a front face, and a rear face of the electronic device.

The light emitted from the light source may provide, through flickering periods or colors, various pieces of information, such as a charged state, the reception of a message or a call, or a call during absence. The flickering periods or colors of the light source for providing such information may be set by the user as desired through a set menu.

The electronic device according to various embodiments enables a metallic material of the case member (e.g., a conductive material) to be used as an antenna device by partially insulating the metallic material, and is able to provide a lighting decoration through an insulative material portion. Accordingly, even if there is a disparate feeling between the conductive material portion and the insulative material portion, it is possible to make the exterior appearance of the electronic device beautiful by utilizing the insulative material portion as a decorative lighting. In addition, when the user differently sets the lighting as desired, various visual effects can be implemented on the exterior appearance of the electronic device according to various embodiments of the present disclosure. For the electronic device, since different visual effects can be implemented depending on the user's setting even with the same product, the exterior appearance of the electronic device can be diversified.

Before undertaking the DETAILED DESCRIPTION below, it may be advantageous to set forth definitions of certain words and phrases used throughout this patent document: the terms "include" and "comprise," as well as derivatives thereof, mean inclusion without limitation; the term "or," is inclusive, meaning and/or; the phrases "associated with" and "associated therewith," as well as derivatives thereof, may mean to include, be included within, interconnect with, contain, be contained within, connect to or with, couple to or with, be communicable with, cooperate with, interleave, juxtapose, be proximate to, be bound to or with, have, have a property of, or the like; and the term "controller" means any device, system or part thereof that controls at least one operation, such a device may be implemented in hardware, firmware or software, or some combination of at least two of the same. It should be noted that the functionality associated with any particular controller may be centralized or distributed, whether locally or remotely. Definitions for certain words and phrases are provided throughout this patent document, those of ordinary skill in the art should understand that in many, if not most instances, such definitions apply to prior, as well as future uses of such defined words and phrases.

### BRIEF DESCRIPTION OF THE DRAWINGS

For a more complete understanding of the present disclosure and its advantages, reference is now made to the following description taken in conjunction with the accompanying drawings, in which like reference numerals represent like parts:
FIG. 1 illustrates an electronic device according to various embodiments of the present disclosure;
FIG. 2 illustrates an electronic device according to a first one of various embodiments of the present disclosure;
FIG. 3 illustrates the electronic device according to the first one of various embodiments of the present disclosure;
FIG. 4 illustrates a portion of the electronic device according to the first one of various embodiments of the present disclosure;
FIG. 5 illustrates a configuration of a portion of the electronic device according to the first one of various embodiments of the present disclosure;
FIG. 6 illustrates a portion of an electronic device according to a second one of various embodiments of the present disclosure;
FIG. 7 illustrates a portion of the electronic device according to a third one of various embodiments of the present disclosure;
FIG. 8 illustrates a configuration of a portion of the electronic device according to the third one of various embodiments of the present disclosure; and
FIG. 9 illustrates a flowchart for describing a method of operating a light-emitting mode of an electronic device according to various embodiments of the present disclosure.

### DETAILED DESCRIPTION

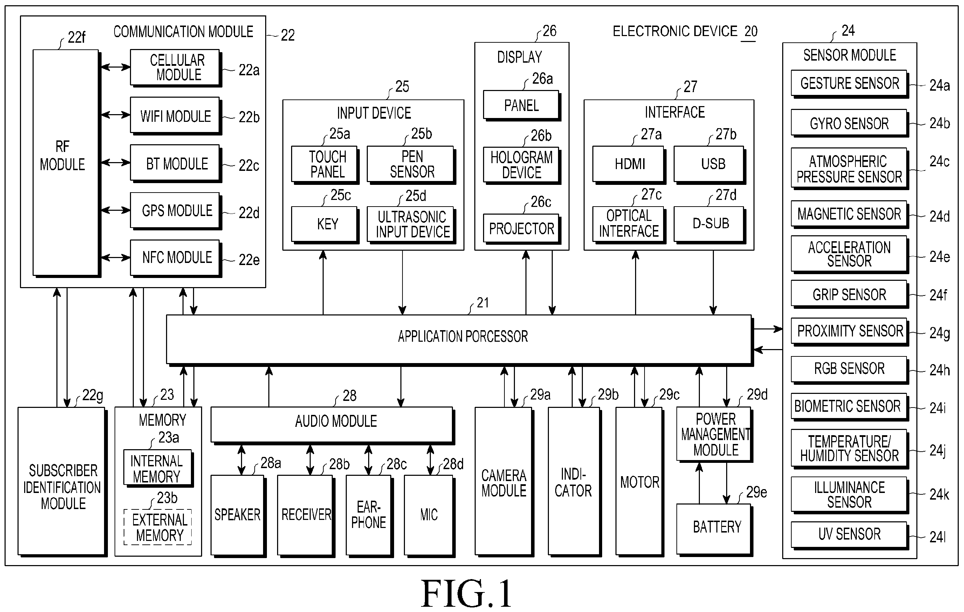

FIGURES 1 through 9, discussed below, and the various embodiments used to describe the principles of the present disclosure in this patent document are by way of illustration only and should not be construed in any way to limit the scope of the disclosure. Those skilled in the art will understand that the principles of the present disclosure may be implemented in any suitably arranged device. Hereinafter, various embodiments of the present disclosure will be described with reference to the accompanying drawings. However, it should be understood that there is no intent to limit the present disclosure to the particular forms disclosed herein; rather, the present disclosure should be construed to cover various modifications, equivalents, or alternatives of embodiments of the present disclosure. In the description of the drawings, similar reference numerals may be used to designate similar elements.

In the present disclosure, the expression "A or B", "at least one of A or/and B", or "one or more of A or/and B" may include all possible combinations of the items listed. For example, the expression "A or B", "at least one of A and B", or "at least one of A or B" refers to all of (1) including at least one A, (2) including at least one B, or (3) including all of at least one A and at least one B.

The expression "a first", "a second", "the first", or "the second" used in various embodiments of the present disclosure may modify various components regardless of the order or the importance but does not limit the corresponding components. For example, a first user device and a second user device indicate different user devices although both of them are user devices. For example, a first element may be termed a second element, and similarly, a second element may be termed a first element without departing from the scope of the present disclosure.

It should be understood that when an element (e.g., first element) is referred to as being (operatively or communicatively) "connected," or "coupled," to another element (e.g., second element), it may be directly connected or coupled directly to the other element or any other element (e.g., third element) may be interposer between them. In contrast, it may be understood that when an element (e.g., first element) is referred to as being "directly connected," or "directly coupled" to another element (second element), there are no element (e.g., third element) interposed between them.

The expression "configured to" used in the present disclosure may be exchanged with, for example, "suitable for", "having the capacity to", "designed to", "adapted to", "made to", or "capable of" according to the situation. The term "configured to" may not necessarily imply "specifically designed to" in hardware. Alternatively, in some situations, the expression "device configured to" may mean that the device, together with other devices or components, "is able to". For example, the phrase "processor adapted (or configured) to perform A, B, and C" may mean a dedicated processor (e.g. embedded processor) only for performing the corresponding operations or a generic-purpose processor (e.g., central processing unit (CPU) or application processor (AP)) that can perform the corresponding operations by executing one or more software programs stored in a memory device.

In the present disclosure, the terms are used to describe specific embodiments, and are not intended to limit the present disclosure. As used herein, the singular forms are intended to include the plural forms as well, unless the context clearly indicates otherwise. In the description, it should be understood that the terms "include" or "have" indicate existence of a feature, a number, a step, an operation, a structural element, parts, or a combination thereof, and do not previously exclude the existences or probability of addition of one or more another features, numeral, steps, operations, structural elements, parts, or combinations thereof.

Unless defined differently, all terms used herein, which include technical terminologies or scientific terminologies, have the same meaning as that understood by a person skilled in the art to which the present disclosure belongs. Such terms as those defined in a generally used dictionary are to be interpreted to have the meanings equal to the contextual meanings in the relevant field of art, and are not to be interpreted to have ideal or excessively formal meanings unless clearly defined in the present specification. In some cases, even the term defined in the present disclosure should not be interpreted to exclude embodiments of the present disclosure.

In the present disclosure, an electronic device may be a random device, and the electronic device may be called a terminal, a portable terminal, a mobile terminal, a communication terminal, a portable communication terminal, a portable mobile terminal, a display device or the like.

For example, the electronic device may be a smartphone, a portable phone, a game player, a TV, a display unit, a heads-up display unit for a vehicle, a notebook computer, a laptop computer, a tablet personal computer (PC), a personal media player (PMP), a personal digital assistant (PDA), and the like. The electronic device may be implemented as a portable communication terminal that has a wireless communication function and a pocket size. Further, the electronic device may be a flexible device or a flexible display device.

The electronic device may communicate with an external electronic device, such as a server or the like, or perform an operation through an interworking with the external electronic device. For example, the electronic device may transmit an image photographed by a camera or position information detected by a sensor unit to the server through a network. The network may be a mobile or cellular communication network, a local area network (LAN), a Wireless local area network (WLAN), a wide area network (WAN), an Internet, a small area network (SAN) or the like, but is not limited thereto.

FIG. 1 is a block diagram illustrating an electronic device 20 according to various embodiments of the present disclosure.

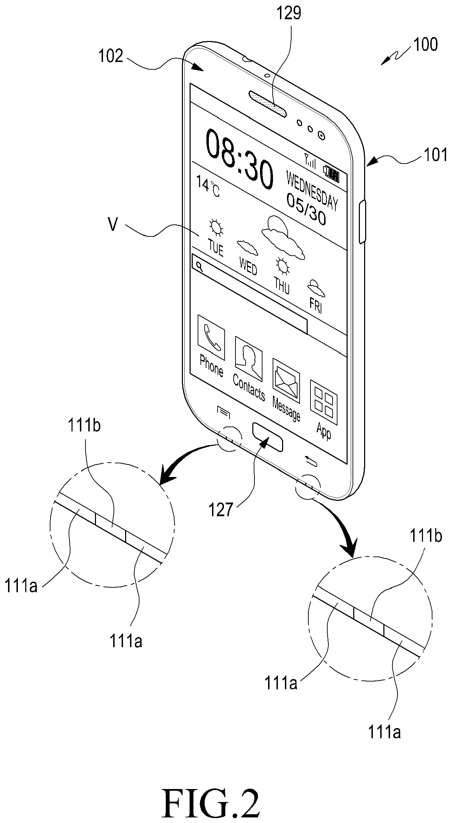

Referring to FIG. 1, the electronic device 20 may include, for example, the whole or a portion of an electronic device 100 to be described later (see, e.g., FIG. 2). The electronic device 20 may include at least one application processor (AP) 21, a communication module 22, a subscriber identification module 22g, a memory 23, a sensor module 24, an input device 25, a display 26, an interface 27, an audio module 28, a camera module 29a, a power management module 29d, a battery 29e, an indicator 29b, and a motor 29c.

The AP 21 may drive, for example, an operating system or an application program so as to control a plurality of hardware or software components connected thereto, and may also perform various data processing and arithmetic operations. The AP 21 may be implemented by, for example, a system-on-chip (SoC). According to one embodiment, the AP 21 may further include a graphic processing unit (GPU) or an image signal processor. The AP 21 may include at least some components (e.g., the cellular module 22a) among the components illustrated in FIG. 1. The AP 21 may load a command or data received from at least one of the other components (e.g., a non-volatile memory) in a volatile memory to process the command and data, and may store various data in a non-volatile memory.

The communication module 22 may include, for example, a cellular module 22a, a WiFi module 22b, a Bluetooth module 22c, a GNSS module 22d (e.g., GPS module, Glonass module, Beidou module, or Galileo module), an NFC module 22e, and a radio frequency (RF) module 22f.

The cellular module 22a may provide, for example, a voice call, a video call, a message service, or an internet service through, for example, a communication network. According to one embodiment, the cellular module 22a may perform discrimination and authentication of the electronic device 20 within the communication network by using the subscriber identification module (e.g., a SIM card) 22g. According to one embodiment, the cellular module 22a may perform at least some of the functions that may be provided by the AP 21. According to one embodiment, the cellular module 22a may include a communication processor.

Each of the WiFi module 22b, the BLUETOOTH module 22c, the GNSS module 22d, and the NFC module 22e may include, for example, a processor to process data transmitted/received through a corresponding module. According to a certain embodiment, at least some (e.g., two or more) of the cellular module 22a, the WiFi module 22b, the Bluetooth module 22c, the GNSS module 22d, and the NFC module 22e may be incorporated in a single integrated chip (IC) or an IC package.

The RF module 22f may transmit or receive, for example, a communication signal (e.g., an RF signal). The RF module 22f may include, for example, a transceiver, a power amp module (PAM), a frequency filter, a low noise amplifier (LNA), or an antenna. According to another embodiment, at least one of the cellular module 22a, the WiFi module 22b, the BLUETOOTH module 22c, the GPS module 22d, and the NFC module 22e may transmit/receive an RF signal through one or more separate RF modules.

The above-mentioned communication module 22 or RF module 22f may transmit or receive an RF signal through at least one of conductive elements 111a (see, e.g., FIG. 2) to be described later. For example, the conductive elements 111a to be described later may be utilized as a radiator for transmitting or receiving an RF signal.

The subscriber identification module 22g may include, for example, a card that includes a subscriber identification module or an embedded SIM, and may also include intrinsic identification information (e.g., integrated circuit card identifier (ICCID)) or subscriber information (e.g., international mobile subscriber identity (IMSI)).

The memory 23 may include, for example, an internal memory 23a or an external memory 23b. The internal memory 23a may include at least one of, for example, a volatile memory (e.g., dynamic RAM (DRAM), static RAM (SRAM), or synchronous DRAM (SDRAM)), a non-volatile memory (e.g., one time programmable ROM (OTPROM), programmable ROM (PROM), erasable and programmable ROM (EPROM), electrically erasable and programmable ROM (EEPROM), mask ROM, flash ROM, flash memory (e.g., NAND flash memory, or NOR flash memory), hard drive, or solid state drive (SSD)).

The external memory 23b may further include a flash drive (e.g., compact flash (CF), secure digital (SD), micro secure digital (Micro-SD), mini secure digital (Mini-SD), extreme digital (xD), multi-media card (MMC), or memory stick). The external memory 23b may be functionally or physically connected to the electronic device 20 through various interfaces.

For example, the sensor module 24 may measure a physical quantity or may sense an operating state of the electronic device 20, and may then convert the measured or sensed information into electric signals. The sensor module 24 may include at least one of, for example, a gesture sensor 24a, a gyro sensor 24b, an atmospheric pressure sensor 24c, a magnetic sensor 24d, an acceleration sensor 24e, a grip sensor 24f, a proximity sensor 24g, a color sensor 24h (e.g., RGB (red, green, blue) sensor), a biometric sensor 24i, a temperature/humidity sensor 24j, an illuminance sensor 24k, and a ultra-violet (UV) sensor 241. Additionally or alternatively, the sensor module 24 may include, for example, an E-nose sensor, an electromyography (EMG) sensor (not illustrated), an electroencephalogram (EEG) sensor, an electrocardiogram (ECG) sensor, an infra-red (IR) sensor, an iris sensor, or a fingerprint sensor. The sensor module 24 may further include a control circuit for controlling one or more sensors incorporated therein. In a certain embodiment, the electronic device 20 may further include a processor configured to control the sensor module 24 as a part of the AP 21 or separate from the AP 21 so as to control the sensor module 24 while the AP 21 is in the sleep state.

The input device 25 may include, for example, a touch panel 25a, a (digital) pen sensor 25b, a key 25c, or an ultrasonic input device 25d. As the touch panel 25a, at least one of, for example, a capacitive type touch panel, a resistive type touch panel, an infrared type touch panel, and an ultrasonic type touch panel may be used. In addition, the touch panel 25a may further include a control circuit. The touch panel 25a may further include a tactile layer so as to provide a tactile reaction to a user.

The (digital) pen sensor 25b may be, for example, a portion of the touch panel or may include a separate recognition sheet. The key 25c may include, for example, a physical button, an optical key, or a keypad. The ultrasonic input device 25d may sense, through a microphone (e.g., a microphone 28d) in the electronic device 20, ultrasonic waves that are generated by an input tool so as to confirm data corresponding to the sensed ultrasonic waves.

The display 26 may include a panel 26a, a hologram device 26b, or a projector 26c. The panel 26a may be implemented to be flexible, transparent, or wearable. The panel 26a may be configured as a single module with the touch panel 25a. The hologram device 26b may show a stereoscopic image in the air using interference of light. The projector 26c may project light onto a screen so as to display an image. The screen may be located, for example, inside or outside the electronic device 20. According to one embodiment, the display 26 may further include a control circuit to control the panel 26a, the hologram device 26b, or the projector 26c.

The interface 27 may include, for example, a high-definition multimedia interface (HDMI) 27a, a universal serial bus (USB) 27b, an optical interface 27c, or a D-subminiature (D-sub) 27d. Additionally or alternatively, the interface 27 may include, for example, a mobile high-definition link (MHL) interface, a secure digital (SD) card/multi-media card (MMC) interface, or an infrared data association (IrDA) standard interface.

The audio module 28 may bi-directionally convert, for example, sound and electric signals. The audio module 28 may process sound information input or output through, for example, a speaker 28a, a receiver 28b, an earphone 28c, or a microphone 28d.

The camera module 29a is a device that is capable of photographing, for example, a still image and a moving image. According to one embodiment, the camera module 29a may include one or more image sensors (e.g., a front sensor or a rear sensor), a lens, an image signal processor (ISP), or a flash (e.g., LED or xenon lamp).

The power management module 29d may manage, for example, the electric power of the electronic device 20. According to one embodiment, the power management module 29d may include a power management integrated circuit (PMIC), a charger integrated circuit (IC), or a battery or fuel gauge. The PMIC may be configured in a wired or wireless charge type. The wireless charge type may include, for example, a magnetic resonance type, a magnetic induction type, or an electromagnetic wave type, and may further include an additional circuit for wireless charging (e.g., a coil loop, a resonance circuit, or a rectifier). The battery gauge may measure the residual capacity of the battery 29e, and a voltage, a current, or a temperature during the charge. The battery 29e may include, for example, a rechargeable battery or a solar battery.

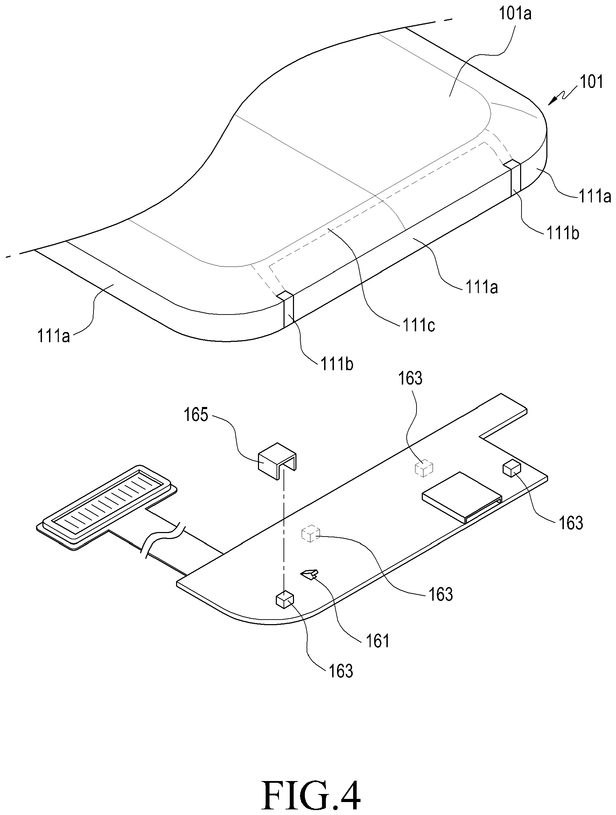

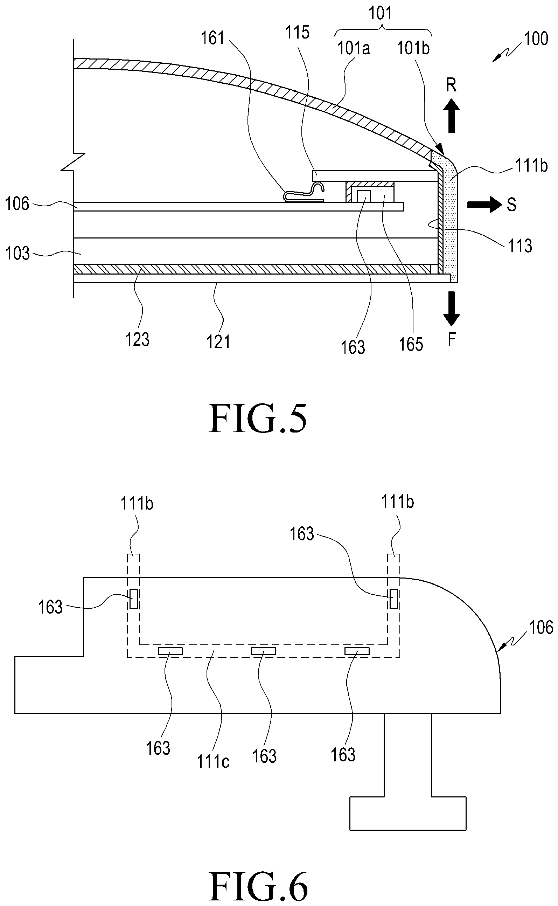

The indicator 29b may indicate a specific state of the electronic device 20 or of a part thereof (e.g., the AP 21), such as a booting state, a message state, or a charged state. The above-mentioned indicator 29b may be implemented through a light source 163 (see, e.g., FIGS. 4 and 5) to be described below. The motor 29c may convert an electric signal into a mechanical vibration, and may generate, for example, a vibration or a haptic effect. Although not illustrated, the electronic device 20 may include a processor (e.g., a GPU) to support a mobile TV. The processor to support a mobile TV may process media data according to the standards of, for example, digital multimedia broadcasting (DMB), digital video broadcasting (DVB), or MediaFLOTM.

Each of the above-described component elements of hardware according to the present disclosure may be configured with one or more components, and the names of the corresponding component elements may vary based on the type of electronic device. The electronic device according to various embodiments of the present disclosure may include at least one of the aforementioned elements. Some elements may be omitted or other additional elements may be further included in the electronic device. Also, some of the hardware components according to various embodiments may be combined into one entity, which may perform functions identical to those of the relevant components before the combination.

The term "module" as used herein may, for example, mean a unit including one of hardware, software, and firmware or a combination of two or more of them. The "module" may be interchangeably used with, for example, the term "unit", "logic", "logical block", "component", or "circuit". The "module" may be a minimum unit of an integrated component element or a part thereof. The "module" may be a minimum unit for performing one or more functions or a part thereof. The "module" may be mechanically or electronically implemented. For example, the "module" according to the present disclosure may include at least one of an application-specific integrated circuit (ASIC) chip, a field-programmable gate arrays (FPGA), and a programmable-logic device for performing operations that have been known or are to be developed hereinafter.

According to various embodiments, at least some of the devices (for example, modules or functions thereof) or the method (for example, operations) according to the present disclosure may be implemented by a command stored in a computer-readable storage medium in a programming module form. The instruction, when executed by a processor (e.g., the processor 21), may cause the one or more processors to execute the function corresponding to the instruction. The computer-readable storage medium may be, for example, the memory 23.

The computer readable recoding medium may include a hard disk, a floppy disk, magnetic media (e.g., a magnetic tape), optical media (e.g., a compact disc read only memory (CD-ROM) and a digital versatile disc (DVD)), magneto-optical media (e.g., a floptical disk), a hardware device (e.g., a read only memory (ROM), a random access memory (RAM), a flash memory), and the like. In addition, the program instructions may include high class language codes, which can be executed in a computer by using an interpreter, as well as machine codes made by a compiler. The aforementioned hardware device may be configured to operate as one or more software modules in order to perform the operation of the present disclosure, and vice versa.

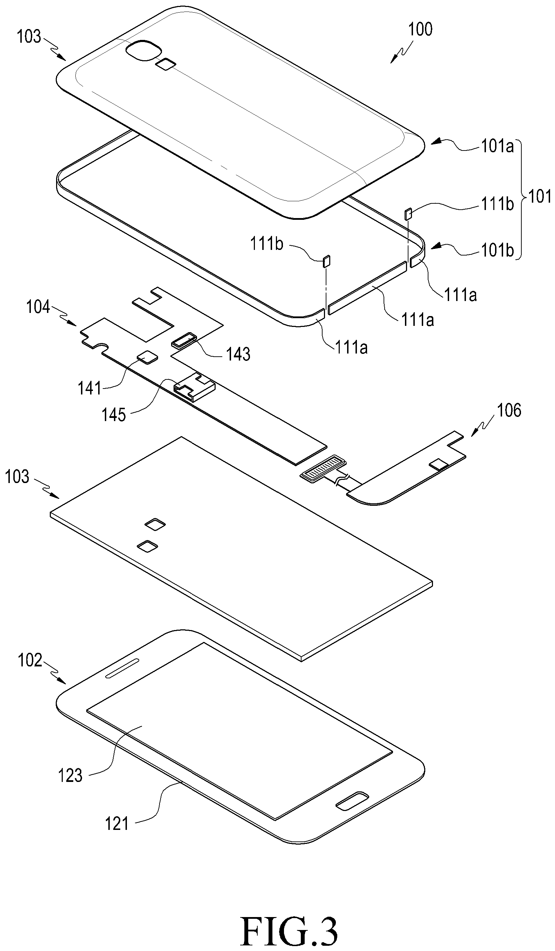

FIG. 2 is a perspective view illustrating an electronic device 100 according to a first one of various embodiments of the present disclosure. FIG. 3 is an exploded perspective view illustrating the electronic device 100 according to the first one of various embodiments of the present disclosure.

Referring to FIGS. 2 and 3, the electronic device 100 may include a case member 101 that is opened at the front side. The electronic device 100 may include the whole or a portion of the electronic device 20 described above. FIG. 3 exemplifies a configuration of the case member 101 in which a rear member 101a and a side wall member 101b are separated from each other, merely for the purpose of more clearly and concisely illustrating the configuration of the case member 101. For example, the side wall member 101b may include a conductive element(s) 111a and an insulative element(s) 111b, and may be integrally arranged with the rear member 101a through a process, such as insert injection molding.

The conductive element(s) 111a may be arranged along the peripheral edge of one face of the case member 101 (e.g., one face of the rear member 101a) so as to form at least a portion of the side wall of the case member 101. The insulative element 111b may be disposed between every two adjacent conductive elements 111a so as to form the side wall of the case member 101 together with the conductive elements 111a. The insulative element(s) 111b may be made of a material that is the same as that of the rear member 101a. More specifically, the insulative element(s) 111b may be made of a transparent or translucent material to transmit light therethrough. If the rear member 101a is a component that conceals the internal space of the case member 101, and, for example, the rear member 101a is made of an opaque material, the insulative element(s) 111b may be made of a material that is different from that of the rear member 101a. The insulative element 111b may be disposed between every two adjacent conductive elements 111a so as to insulate the conductive elements 111a from each other.

The electronic device 100 may further include a front cover 102 that is mounted on the front side of the case member 101. The front cover 102 may implement, for example, a display device. The front cover 102 may include a window member 121 that covers the front side of the case member 101 and a display element 123 that is disposed on the window member 121. A screen, which is implemented from the display element 123, may be transmitted through the window member 121 to be output. An input/output device, such as a keypad 127 or a receiver unit 129, may be arranged around the screen transmission region V on the window member 121.

In fastening the front cover 102 to the case member 101, the side wall member 101b (e.g., the conductive elements 111a and the insulative elements 111b) may be fastened to enclose the peripheral edge of the front cover 102 (e.g., the window member 121). As a result, the window member 121 may be coupled to the case member while facing the one face of the case member 101 (e.g., one face of the rear member 101a), and the conductive element(s) 111a or the insulative element(s) 111b may be partially exposed to the front side of the case member 101.

The case member 101 may accommodate circuit boards 104 and 106 therein. The circuit boards 104 and 106 may be implemented as a single piece or a plurality of pieces according to an arrangement of the internal space of the case member 101. The present embodiment exemplifies a configuration in which first and second circuit boards 104 and 106 are disposed within the case member 101. Electronic components (e.g., one or more IC chip 141 that implements, for example, an application processor (AP), a communication module, a memory, an audio module, or a power management module, various sensors and connectors 143, a storage medium socket 145, and a connection terminal 161 (see, e.g., FIG. 4) to be connected to a portion of an antenna device or an external device) may be disposed on the circuit boards 104 and 106. The various electronic components recited above may be distributed and arranged on the first and second circuit boards 104 and 106, respectively. When a plurality of circuit boards are arranged within the case member 101, a connection means, such as a flexible printed circuit board, may be further provided inside the case member 101 so as to interconnect the circuit boards 104 and 106.

The electronic device 100 may further include a support member 103 that is accommodated in the case member 101. The support member 103 may improve the mechanical rigidity of the electronic device 100, and may protect and isolate various electronic components within the electronic device 100 in relation to each other. For example, various electronic components, such as the IC chip 141, are mounted on the circuit boards 104 and 106. When the electronic components directly face and come in contact with the front cover 102 (e.g., the display element. 121), the display element 121 may be damaged. The support member 103 may be arranged between the first and second circuit boards 104 and 106 and the display element 121 so as to block the electronic components from coming into direct contact with the display element 121.

In addition, the support member 103 may shield electromagnetic waves that are generated by the above-mentioned electronic components while the electronic components operate, thereby blocking the electromagnetic waves from influencing the operation of the other electronic components. For example, when the support member 103 is arranged, the display element 121 may conduct a stable operation without being influenced by the electromagnetic waves that are generated by the other electronic components. In addition, the support member 103 may provide various structures, on which the first and second circuit boards 104 and 106 may be fixedly mounted, and may support the front cover 102 so as to maintain the front cover 102 in the flat shape.

FIG. 4 is an exploded perspective view illustrating a portion of the electronic device 100 according to the first one of various embodiments of the present disclosure. FIG. 5 is a cross-sectional view illustrating a configuration of a portion of an electronic device 100 according to the first one of various embodiments of the present disclosure. FIG. 6 is a plan view illustrating a portion of an electronic device 100 according to a second one of various embodiments of the present disclosure.

Referring to FIGS. 4 to 6, the electronic device 100 may include a light source(s) 163. The light source(s) 163 may emit light, and the light emitted from the light source 163 may be emitted and/or transmitted to the outside through the insulative element(s) 111b. The light source(s) 163 may include a light emitting diode (LED), and may be mounted on one of the circuit boards 104 and 106 to be positioned to be adjacent to the insulative element(s) 111b. While forming the side wall of the case member 101, a portion of the insulative element 111b may be exposed to the front side of the electronic device 100, and the remaining portion of the insulative element 111b may be exposed to the rear side of the electronic device 100. For example, the light emitted from the light source 163 may be emitted and/or transmitted to the outside through the insulative element and through at least one portion of the front face, the side face, and the rear face of the electronic device (arrows F, S, and R). When a plurality of insulative elements 111b are arranged on the side wall of the case member 101, a plurality of light sources 163 may be arranged to be adjacent to the arrangement positions of the insulative elements 111b, respectively. The light sources 163 may implement various visual effects using, for example, light-emitting colors, or flickering periods or patterns, and may also indicate state information of the electronic device 100. For example, if the electronic device 100 is on the way of being charged, the charged state may be indicated through the light-emitting colors of the light sources 163. When a call or a message is received through the electronic device 100, the light sources 163 may flicker so as to allow the user to recognize it. As described above, the visual effects or simple information indication using the light sources 163 may be differently implemented through the user's setting.

According to various embodiments, the insulative elements 111b and 111c may extend from a first location on the side face of the case member 101 to a second location on the side face of the case member 101 across a portion of one face or the other face of the case member 101 (e.g., the rear member 101a). In the case where the insulative elements 111b and 111c extend across a portion of one face or the other face of the case member 101, more light sources 163 may be arranged along the trace in which the insulative elements 111b and 111c extend, as illustrated in FIG. 6.

By arranging a proper number of light sources 163 according to the size and arranged trace of the insulative elements 111b and 111c, the lighting may be more variously set. In addition, as the light sources 163 are arranged more closely to each other, uniform lighting may be provided over all the insulative elements 111b and 111c. However, if the electronic device 100 is a portable device and is supplied with power from a battery with a limited capacity, the number of light sources 163 may be reduced in order to reduce power consumption. When the electronic device further includes a light transfer member 113, more uniform lighting may be provided over all the insulative elements 111b and 111c even if the number of the light sources 163 is reduced.

Referring to FIG. 5, the light transfer member 113 may be attached to the inner surface of the case member 101 (e.g., at least the inner surface of the insulative element 111b), and may transfer and diffuse the light emitted from the light sources 163 to all the insulative elements 111b. The light transfer member 113 may be implemented by using, for example, a light guide plate (e.g., a light guide film) or a light diffusion plate (e.g., a light diffusion film). As the light transfer member 113 is arranged, the electronic device 100 may emit uniform light through all the insulative elements 111b even if fewer light sources 163 are arranged therein.

According to various embodiments, any one of the conductive elements 111a may implement a portion of an antenna device. For example, among the conductive elements 111a, a first conductive element may be connected to a communication module of the electronic device 100 (e.g., the above-mentioned communication module 22) to be utilized as a radiation conductor. The communication module of the electronic device 100 may be incorporated into the IC chip 141. The conductive element 111a to be utilized as a radiation conductor may be insulated from the other conductive portion of the case member 101 (e.g., the second conductive elements) by the insulative elements 111b.

Referring to FIG. 5, a connection piece 115 may extend from the inner surface of the conductive element 111a to be utilized as the radiation conductor. The connection piece 115 may be buried to a synthetic resin portion that forms the rear member 101 to be at least partially exposed from one face (e.g., the inner surface) of the case member 101, and may be positioned to face the circuit board 106. A connection terminal 161 may be installed to the circuit board 106 to be electrically contacted with the connection piece 115. The connection terminal 161 may be connected to the communication module of the electronic device 100 through, for example, a printed circuit pattern formed on the circuit board 106 so as to feed power to the connection piece 115 or the conductive element 111a. As a result, at least one of the conductive elements 111a may be used as a radiation conductor of the electronic device 100 to transmit/receive an RF signal while forming a portion of the side wall of the case member 101. The connection piece 115 may be formed at a proper position in consideration of a resonance frequency required for the electronic device 100 or a specification (e.g., a length) of the conductive element(s) 111a. According to various embodiments, the connection piece 115 may be formed to be adjacent to one end of the conductive element(s) 111a. When any one of the insulative element s 111b is disposed to be in contact with the end of the conductive element 111a disposed adjacent to the connection piece 115, the connection terminal 161 and the light sources 163 may be disposed to be adjacent to each other.

According to various embodiments, the electronic device 100 may further include a guide member 165. The guide member 165 may cause the light emitted from the light sources 163 to progress toward the insulative elements 111b or the light transfer member 113 so that the lighting efficiency can be enhanced. In addition, the guide member 165 can prevent the light, which is emitted from the light sources 163, from leaking out to a route other than the insulative elements 111b so that the degree of completion of the electronic device 100 (e.g., the quality of exterior appearance of the electronic device 100) can be further enhanced. For example, the guide member 165 can prevent the light from leaking out to a portion other than a designed location (e.g., a portion where the insulative elements 111b are disposed).

The guide member 165 may be mounted on the circuit board 106 in the state of enclosing the light sources 163. The light emitted from the light sources 163 may progress in various directions by, for example, scattering. However, the guide member 165 may cause the light emitted from the light sources 163 to progress toward the insulative elements 111b or the light transfer member 113 so that the lighting efficiency can be enhanced. When the inner surface of the guide member 165 is coated with a reflective substance, the lighting efficiency of the light sources 163 can be further improved. Since each of the insulative elements 111b may be at least partially disposed on the front face, the side face, or the rear face of the electronic device 100, the light emitted from the light sources 163 may provide the lighting effect to each of the front face, the side face, and the rear face of the electronic device 100 (arrows F, S, and R).

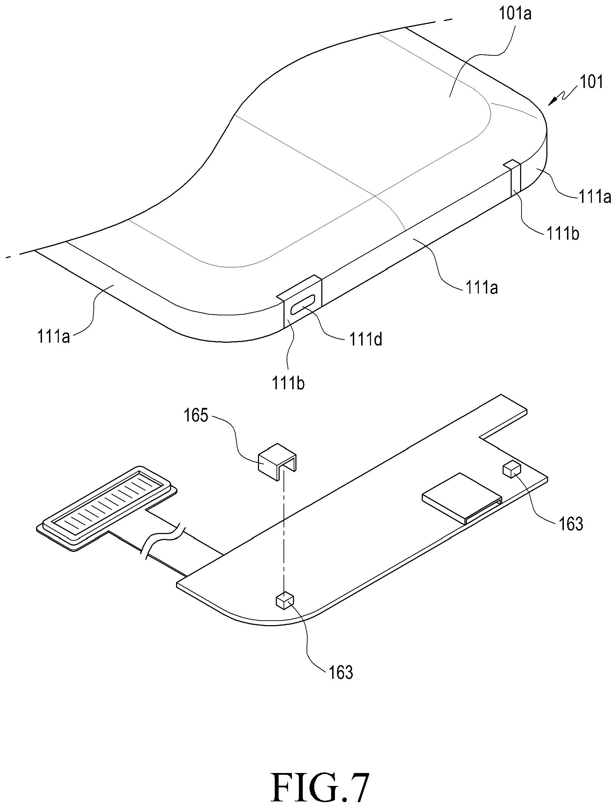

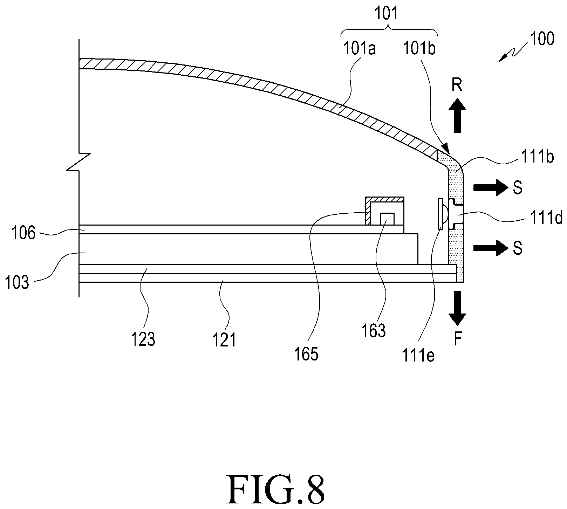

FIG. 7 is an exploded perspective view illustrating a portion of an electronic device 100 according to a third one of various embodiments of the present disclosure. FIG. 8 is a cross-sectional view illustrating a configuration of a portion of the electronic device 100 according to the third one of various embodiments of the present disclosure.

In describing the configuration of the electronic device 100 according to the present embodiment, the components that are the same as those of the preceding embodiment or that can be easily understood through the preceding embodiment may be denoted by the same reference numerals or the reference numerals may be omitted, and the detailed descriptions thereof may also be omitted.

Referring to FIGS. 7 and 8, the electronic device 100 may further include a button 111d exposed to the side face of the case member 101 (e.g., the outer face of the side wall member 101b). The button 111d may be disposed on the case member 101 through the insulative element 111b. For example, the button 111d may be disposed such that a portion of the button 111d is positioned on the inner surface of the case member 101, and the other portion is positioned on the outer face of the case member 101. Another circuit board (e.g., a dome sheet 111e) may be disposed inside the case member 101. The dome sheet 111e may be positioned to face the above-mentioned portion (e.g., the inner surface) of the button 111d. The user may operate the dome sheet 111e by pushing the button 111d from the outside of the case member 101. The button 111d may be used as, for example, a power key or a volume adjustment key.

The insulative element 111b may be made of a transparent or translucent material so as to diffuse light therein or to transmit light therethrough. For example, the light emitted from a light source 163 may be diffused into the inside of an insulative element 111b or may be emitted and/or transmitted to the outside through the insulative element 111b. On the outer face of the case member 101, the button 111d may be disposed in the state of being enclosed by the insulative element 111b. For example, the light emitted from the light source 163 may provide ornamental lighting around the button 111d on the outer face of the case member 101. In addition, since the insulative element 111b may be at least partially disposed on each of the front face, the side face, and the rear face of the electronic device 100, the light emitted from the light source 163 may provide the lighting effect to each of the front face, the side face, and the rear face of the electronic device 100 (arrows F, S, and R).

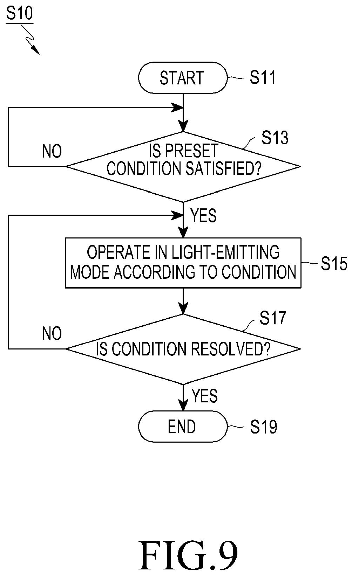

The light emitted and/or transmitted from the insulative element(s) 111b of the above-described embodiments may provide various pieces of information to the user. Hereinafter, descriptions will be made on a configuration of providing various pieces of information to a user using light emitted and/or transmitted through the insulative element(s) 111b with reference to FIG. 9.

FIG. 9 is a flowchart for describing a light-emitting mode operating method S10 of an electronic device according to various embodiments of the present disclosure.

Referring to FIG. 9, the light-emitting mode operating method S10 of an electronic device may provide various pieces of information to a user by causing the light source(s) to emit light or to flicker according to a preset condition.

In operation S11, when the electronic device is driven (start step), a control unit (e.g., the above-mentioned processor 21) may be activated so as to cause the light source(s) 163 (e.g., the above-mentioned indicator 29b) to emit light or to flicker according to a preset condition that was set in advance, for example, at the manufacturing step thereof or by the user.

In operation S13, at a step of determining whether a preset condition is satisfied, the processor 21 may determine whether a generated event corresponds to one of preset conditions through a comparison. Here, the "preset condition" refers to a condition that causes the light source(s) 163 to be turned ON or to flicker, and may include, for example, a battery charge state, reception of a call or a message during absence, an emergency message related to disaster information, and reception of a call or a message from a designated phone number.

In operation S15, when an event corresponding to a preset condition is generated, the processor 21 may cause the light source(s) 163 to be turned ON or to flicker in a light-emitting mode according to a satisfied condition. The light-emitting mode of the light sources 163 may be variously set. For example, the light-emitting mode of the light sources 163 may include a mode in which the light sources 163 are turned ON in a first, second, or third color, a mode in which the light source 163 slowly flicker (e.g., once or twice per second) in the first, second, or third color, a mode in which the light sources 163 rapidly flicker (e.g., five or more times per second) in the first, second, or third color, and a mode in which the light sources are sequentially or circularly changed to the first, second, and third colors. Various light-emitting modes may be implemented using, for example, the colors of light emitted from the light sources 163 and the flickering frequency of the light sources 163.

For example, it is desired to indicate the battery charge state through the light-emitting mode of a light source 163, the light source 163 may be set to emit light gradually from red light to green light as the charging proceeds. In addition, the light source 163 may be set to emit red light in the state where the battery (e.g., the above-mentioned battery 29e) is not fully charged, and to emit green light in the state where the battery 163 is fully charged.

When it is desired to indicate that there was a call during absence through the light-emitting mode of the light source 163, the light source 163 may be set to slowly flicker while emitting red or blue light. In the case of receiving an emergency message, or a call or a message from a designated phone number, the light source 163 may be set to rapidly flicker with red light. When an operation error or a defective wired or wireless connection state of the electronic device 100 is sensed, the processor 21 may set the light source 163 to slowly flicker while emitting red light.

In operation S17, while the light source 163 is operating in a light-emitting mode according to a condition in operation S15, the processor 21 may determine whether the condition of operating the light source 163 is resolved. Here, the description "a condition is resolved" may mean that the user recognizes that an event is generated and operates the electronic device 100 so as to confirm the generated event. When the condition of operating the light source 163 in the light-emitting mode is not resolved, the processor 21 may make the light source 163 maintain the current light-emitting mode. When the condition of operating the light source 163 in the light-emitting mode is resolved, the processor 21 may terminate the current light-emitting mode. Even in the state where the light-emitting mode is terminated, the processor 21 may receive or monitor whether a new event, which satisfies a preset condition, is generated.

According to various embodiments, the condition may be resolved based on another setting by the user. For example, the user may set, in advance, a time so that the light-emitting mode may operate for the set time only. In operation S19, when the set time has passed in the state where the light source 163 operates in the light-emitting mode, the processor 21 may terminate the light-emitting mode of the light source 163.

In the specific embodiments of the present disclosure, descriptions have been made while exemplifying conditions for operating light-emitting modes and the light-emitting modes operating according to the conditions. However, the conditions and the light-emitting modes may be set in a combination that is different from the above-described combinations. For example, the colors of light that correspond to the charged amount of the battery may be differently set, or the light source may be turned ON during charging and may be made to flicker in the fully charged state. The operating conditions and light-emitting modes may be provided to be selected by the user from a setting menu of the electronic device 100. In addition, the above-described light-emitting modes may be more variously set depending on: the positions where the insulative elements 111b and the light sources 163 are arranged; and the number of the insulative elements 111b and the light sources 163.

As described above, an electronic device, according to various embodiments of the present disclosure, may include: a case member that includes conductive elements that form a side wall around one face of the case member, and an insulative element that is at least partially provided between the conductive elements; and a light source disposed inside the case member. The insulative element may emit and/or transmit light, which is emitted from the light source, to the outside of the case member.

According to various embodiments, the electronic device may further include a waveguide plate that is disposed at least on an inner surface of the insulative element. The light emitted from the light source may be transferred to the inner surface of the insulative element through the waveguide plate.

According to various embodiments, the electronic device may further include a diffusing plate that is disposed at least on the inner surface of the insulative element. The light emitted from the light source may be transferred to the inner surface of the insulative element through the diffusing plate.

According to various embodiments, the electronic device may further include a window member that is coupled to the case member while facing the one face of the case member. The conductive elements and the insulative element may be fastened to enclose a peripheral edge of the window member, and a portion of the insulative element may be exposed to a front side of the case member.

According to various embodiments, the electronic device may further include a circuit board that is accommodated in the case member. The light source may be mounted on the circuit board.

According to various embodiments, the electronic device may further include a guide member that is mounted on the circuit board in a state of enclosing the light source. The guide member may guide light emitted from the light source, to the insulative element.

According to various embodiments, the electronic device may further include a communication module that is mounted on the circuit board. At least one of the conductive elements may transmit/receive a radio frequency signal by receiving power fed from the communication module.

According to various embodiments, the electronic device may further include a connection terminal that is mounted on the circuit board; and a connection piece that extends from the inner surface of the at least one of the conductive elements. When the circuit board is accommodated in the case member, the connection terminal may come into contact with the connection piece so as to connect the at least one of the conductive element to the communication module.

According to various embodiments, the connection terminal may be disposed to be adjacent to the light source.

According to various embodiments, a portion of the insulative element may be positioned on the other face of the case member.

According to various embodiments, the insulative element may extend from a first location of the side wall of the case member to a second location of the side wall of the case member across a portion of the other face of the case member.

According to various embodiments, a plurality of light sources may be arranged along a trace, in which the insulative element extends, at spaced positions, respectively.

According to various embodiments, the insulative element may form a portion of the side wall together with the conductive elements.

While the present disclosure has been shown and described with reference to certain embodiments thereof, it will be understood by those skilled in the art that various changes in form and details may be made therein without departing from the scope of the present disclosure as defined by the appended claims.

Although the present disclosure has been described with an exemplary embodiment, various changes and modifications may be suggested to one skilled in the art. It is intended that the present disclosure encompass such changes and modifications as fall within the scope of the appended claims.

## Claims

1. An electronic device (100) comprising:
a case member (101) that includes conductive elements (111a) that form a side wall (101b) around one face of the case member (101), and an insulative element (111b) at least partially provided between the conductive elements; and
a light source (163) disposed inside the case member (101), wherein a portion of the insulative element (111b) is positioned on the other face of the case member,
wherein the insulative element (111b) is configured to emit and/or transmit light emitted from the light source to the outside of the case member.

2. The electronic device of claim 1, further comprising:
a waveguide plate (113) disposed at least on an inner surface of the insulative element,
wherein the light emitted from the light source is transferred to the inner surface of the insulative element through the waveguide plate.

3. The electronic device of claim 1, further comprising:
a diffusing plate (113) disposed at least on the inner surface of the insulative element,
wherein the light emitted from the light source is transferred to the inner surface of the insulative element through the diffusing plate.

4. The electronic device of claim 1, further comprising:
a window member (121) coupled to the case member while facing the one face of the case member,
wherein the conductive elements and the insulative element are fastened to enclose a peripheral edge of the window member, and a portion of the insulative element is exposed to a front side of the case member.

5. The electronic device of claim 1, further comprising:
a circuit board (106) accommodated in the case member,
wherein the light source is mounted on the circuit board.

6. The electronic device of claim 5, further comprising:
a guide member (165) mounted on the circuit board in a state of enclosing the light source,
wherein the guide member is configured to guide the light emitted from the light source to the insulative element.

7. The electronic device of claim 5, further comprising:
a communication module (141) mounted on the circuit board,
wherein at least one of the conductive elements is configured to transmit or receive a radio frequency signal by receiving power fed from the communication module.

8. The electronic device of claim 7, further comprising:
a connection terminal (161) mounted on the circuit board; and
a connection piece (115) that extends from the inner surface of the at least one of the conductive elements,
wherein, when the circuit board is accommodated in the case member, the connection terminal (161) comes into contact with the connection piece so as to connect the at least one of the conductive element to the communication module.

9. The electronic device of claim 8, wherein the connection terminal (161) is disposed to be adjacent to the light source.

10. The electronic device of claim 1, wherein the insulative element (111b) is configured to extend from a first location of the side wall of the case member to a second location of the side wall of the case member across a portion of the other face of the case member.

11. The electronic device of claim 10, wherein a plurality of light sources (163) are arranged along a trace, in which the insulative element extends, at spaced positions, respectively.

12. The electronic device of claim 1, wherein the insulative element (111b) is configured to form a portion of the side wall together with the conductive elements.

## Patentansprüche

1. Elektronische Vorrichtung (100), die Folgendes umfasst:
ein Gehäuseelement (101), das Folgendes umfasst: leitfähige Elemente (111a), die eine Seitenwand (101b) um eine Seite des Gehäuseelements (101) bilden, und ein isolierendes Element (111b), das mindestens teilweise zwischen den leitfähigen Elementen vorgesehen ist; und
eine Lichtquelle (163), die innerhalb des Gehäuseelements (101) angeordnet ist,
wobei ein Abschnitt des isolierenden Elements (111b) auf der anderen Seite des Gehäuseelements angeordnet ist,
wobei das isolierende Element (111b) dafür konfiguriert ist, von der Lichtquelle emittiertes Licht zur Außenseite des Gehäuseelements zu emittieren und/oder zu übertragen.

2. Elektronische Vorrichtung nach Anspruch 1, die ferner Folgendes umfasst:
eine Wellenleiterplatte (113), die mindestens auf einer inneren Oberfläche des isolierenden Elements angeordnet ist,
wobei das von der Lichtquelle emittierte Licht durch die Wellenleiterplatte auf die innere Oberfläche des isolierenden Elements übertragen wird.

3. Elektronische Vorrichtung nach Anspruch 1, die ferner Folgendes umfasst:
eine Diffusorplatte (113), die mindestens auf der inneren Oberfläche des isolierenden Elements angeordnet ist,
wobei das von der Lichtquelle emittierte Licht durch die Diffusorplatte auf die innere Oberfläche des isolierenden Elements übertragen wird.

4. Elektronische Vorrichtung nach Anspruch 1, die ferner Folgendes umfasst:
ein Fensterelement (121), das mit dem Gehäuseelement verbunden ist, während es der einen Seite des Gehäuseelements zugewandt ist,
wobei die leitfähigen Elemente und das isolierende Element befestigt sind, um eine Umfangskante des Fensterelements zu umschließen, und ein Abschnitt des isolierenden Elements an einer Vorderseite des Gehäuseelements freiliegt.

5. Elektronische Vorrichtung nach Anspruch 1, die ferner Folgendes umfasst:
eine Leiterplatte (106), die in dem Gehäuseelement untergebracht ist,
wobei die Lichtquelle auf der Leiterplatte montiert ist.

6. Elektronische Vorrichtung nach Anspruch 5, die ferner Folgendes umfasst:
ein Führungselement (165), das in einem Zustand, in dem die Lichtquelle eingeschlossen ist, auf der Leiterplatte montiert ist;
wobei das Führungselement dafür konfiguriert ist, das von der Lichtquelle emittierte Licht zu dem isolierenden Element zu leiten.

7. Elektronische Vorrichtung nach Anspruch 5, die ferner Folgendes umfasst:
ein Kommunikationsmodul (141), das auf der Leiterplatte montiert ist,
wobei mindestens eines der leitfähigen Elemente dafür konfiguriert ist, ein Hochfrequenzsignal zu senden oder zu empfangen, indem es Energie empfängt, die von dem Kommunikationsmodul zugeführt wird.

8. Elektronische Vorrichtung nach Anspruch 7, die ferner Folgendes umfasst:
ein Verbindungsanschluss (161), der auf der Leiterplatte montiert ist; und
ein Verbindungsstück (115), das sich von der inneren Oberfläche des mindestens einen der leitfähigen Elemente erstreckt,
wobei, wenn die Leiterplatte in dem Gehäuseelement untergebracht ist, der Verbindungsanschluss (161) in Kontakt mit dem Verbindungsstück kommt, um das mindestens eine leitfähige Element mit dem Kommunikationsmodul zu verbinden.

9. Elektronische Vorrichtung nach Anspruch 8, wobei der Verbindungsanschluss (161) so angeordnet ist, dass er an die Lichtquelle angrenzt.

10. Elektronische Vorrichtung nach Anspruch 1, wobei das isolierende Element (111b) so konfiguriert ist, dass es sich von einem ersten Ort der Seitenwand des Gehäuseelements zu einem zweiten Ort der Seitenwand des Gehäuseelements über einen Abschnitt der anderen Seite des Gehäuseelements erstreckt.

11. Elektronische Vorrichtung nach Anspruch 10, wobei mehrere Lichtquellen (163) entlang einer Spur angeordnet sind, in der sich das isolierende Element jeweils in beabstandeten Positionen erstreckt.

12. Elektronische Vorrichtung nach Anspruch 1, wobei das isolierende Element (111b) dafür konfiguriert ist, einen Abschnitt der Seitenwand zusammen mit den leitfähigen Elementen zu bilden.

## Revendications

1. Un dispositif électronique (100) comprenant :
un élément boîtier (101) qui contient des éléments conducteurs (111a) qui forment une paroi latérale (101b) autour d'une face de l'élément boîtier (101), et un élément isolant (111b) au moins partiellement placé entre les éléments conducteurs, et
une source lumineuse (163) disposée à l'intérieur de l'élément boîtier (101),
où une partie de l'élément isolant (111b) est positionnée sur l'autre face de l'élément boîtier,
où l'élément isolant (111b) est configuré de façon à émettre et/ou transmettre une lumière émise à partir de la source lumineuse vers l'extérieur de l'élément boîtier.

2. Le dispositif électronique selon la Revendication 1, comprenant en outre :
une plaque de guide d'ondes (113) disposée au moins sur une surface intérieure de l'élément isolant,
où la lumière émise à partir de la source lumineuse est transférée vers la surface intérieure de l'élément isolant au travers de la plaque de guide d'ondes.

3. Le dispositif électronique selon la Revendication 1, comprenant en outre :
une plaque de diffusion (113) disposée au moins sur la surface intérieure de l'élément isolant,
où la lumière émise à partir de la source lumineuse est transférée vers la surface intérieure de l'élément isolant au travers de la plaque de diffusion.

4. Le dispositif électronique selon la Revendication 1, comprenant en outre :
un élément fenêtre (121) couplé à l'élément boîtier tout en étant tourné vers ladite face de l'élément boîtier,
où les éléments conducteurs et l'élément isolant sont fixés de façon à enfermer un bord périphérique de l'élément fenêtre, et une partie de l'élément isolant est exposée vers un côté avant de l'élément boîtier.

5. Le dispositif électronique selon la Revendication 1, comprenant en outre :
une carte à circuits imprimés (106) logée dans l'élément boîtier,
où la source lumineuse est montée sur la carte à circuits imprimés.

6. Le dispositif électronique selon la Revendication 5, comprenant en outre :
un élément guide (165) monté sur la carte à circuits imprimés dans un état d'enfermement de la source lumineuse,
où l'élément guide est configuré de façon à guider la lumière émise à partir de la source lumineuse vers l'élément isolant.

7. Le dispositif électronique selon la Revendication 5, comprenant en outre :
un module de communication (141) monté sur la carte à circuits imprimés,
où au moins un des éléments conducteurs est configuré de façon à émettre ou recevoir un signal radioélectrique par la réception d'une alimentation électrique fournie à partir du module de communication.

8. Le dispositif électronique selon la Revendication 7, comprenant en outre :
une borne de connexion (161) montée sur la carte à circuits imprimés, et
une pièce de connexion (115) qui s'étend à partir de la surface intérieure du au moins un des éléments conducteurs,
où, lorsque la carte à circuits imprimés est logée dans l'élément boîtier, la borne de connexion (161) entre en contact avec la pièce de connexion de façon à connecter le au moins un des éléments conducteurs au module de communication.

9. Le dispositif électronique selon la Revendication 8, où la borne de connexion (161) est disposée de façon à être adjacente à la source lumineuse.

10. Le dispositif électronique selon la Revendication 1, où l'élément isolant (111b) est configuré de façon à s'étendre à partir d'un premier emplacement de la paroi latérale de l'élément boîtier vers un deuxième emplacement de la paroi latérale de l'élément boîtier sur une partie de l'autre face de l'élément boîtier.

11. Le dispositif électronique selon la Revendication 10, où une pluralité de sources lumineuses (163) sont agencées le long d'une piste, dans laquelle l'élément isolant s'étend à des positions espacées, respectivement.

12. Le dispositif électronique selon la Revendication 1, où l'élément isolant (111b) est configuré de façon à former une partie de la paroi latérale conjointement avec les éléments conducteurs.
